(19) Europäisches Patentamt
European Patent Office
Office européen des brevets

(11) Publication number: **0 306 031 A2**

(12) # EUROPEAN PATENT APPLICATION

(21) Application number: 88114333.3

(22) Date of filing: 02.09.88

(51) Int. Cl.4: C04B 35/00 , B32B 18/00 , H01L 39/24 , C01G 1/00

Claims for the following Contracting State: ES.

(30) Priority: 12.02.88 US 155341
11.09.87 US 95083
04.09.87 US 94179

(43) Date of publication of application:
08.03.89 Bulletin 89/10

(84) Designated Contracting States:
AT BE CH DE ES FR GB GR IT LI LU NL SE

(71) Applicant: W.R. Grace & Co.-Conn. (a Connecticut corp.)
Grace Plaza 1114 Avenue of the Americas
New York New York 10036(US)

(72) Inventor: Lundsager, Christian Bent
1308 Patuxent Drive
Ashton Maryland 20861(US)
Inventor: Spencer, Nicholas David
5311 42nd Street, N.W.
Washington District of Columbia 20015(US)
Inventor: Pan, Wie Hin
5431 The Bridle Path
Columbia Maryland 21044(US)
Inventor: Rudesill, John Allen
2000 Wildlife Drive
Baltimore Maryland 21207(US)

(74) Representative: Abitz, Walter, Dr.-Ing. et al
Abitz, Morf, Gritschneder, Freiherr von Wittgenstein Postfach 86 01 09
D-8000 München 86(DE)

(54) **Method and composition for forming superconducting ceramics and superconductive products therefrom.**

(57) A method and composition for forming superconducting ceramics is disclosed using certain blends of particles of the ceramic materials (or their precursors) with polymers and plasticizers. In accordance with the invention the blend can be shaped by conventional means, the plasticizer can be removed by extraction and/or volatilization, the polymer can be volatilized, and the particles can be sintered to yield the desired ceramic product. Formation of composite products and products with useful shapes is disclosed.

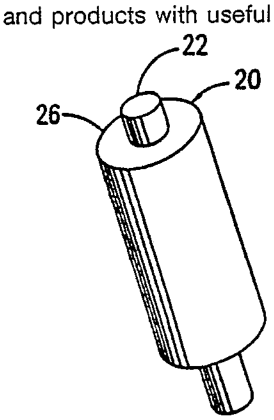


FIG. 2

EP 0 306 031 A2

Xerox Copy Centre

# METHOD AND COMPOSITION FOR FORMING SUPERCONDUCTING CERAMICS AND SUPERCONDUCTIVE PRODUCTS THEREFROM

This application is a continuation-in-part of U.S. Patent Application Serial No. 094,179 filed September 4, 1987, by Lundsager, and this application is also a continuation-in-part of U.S. Patent Application Serial No. 095,083 filed September 11, 1987, by Spencer, Pan, and Rudesill.

## FIELD OF THE INVENTION

This invention relates to superconducting ceramic, and in particular, to producing superconductive ceramic products.

## BACKGROUND OF THE INVENTION

It has long been known that the effective resistivity of certain materials was reduced, and sometimes substantially eliminated, when the material was exposed to low temperature conditions. Of particular interest were the metals and metal oxides which can conduct electricity under certain low temperature conditions with virtually no resistance. These have become known as superconductors. Certain metals, for example, are known to be superconductive when cooled to about 4° on the Kelvin scale (hereinafter °K), and certain niobium alloys and components are known superconductive at about 15°K, some as high as about 23°K. More recently, an oxide containing lanthanum, barium, and copper was discovered which became superconductive at temperatures of about 30°K, and in some circumstances, at temperatures of about 20 degrees higher. Current advances have identified materials which become superconductive at temperatures near 100°K, such that liquid nitrogen cooling could be used. Of special interest are ceramic materials which have reduced electrical resistance properties that are stable over time such that they could be developed for use in practical applications. While the phenomena of reduced electrical resistance and even superconductivity has now been observed at liquid nitrogen temperatures or above, these properties are still considered to be achieved primarily at low temperatures when compared to ambient conditions. However, there is some indication that ceramic materials might be formulated which can reliably exhibit reduced electrical resistance and perhaps superconductivity at ambient conditions.

A composition having an approximate unit cell formula of $Y\ Ba_2\ Cu_3\ O_z$, where z is typically about 7, and various related materials, represent a particularly promising group of ceramics for superconducting applications. In one formulation for these ceramic materials, for example, carbonate and/or oxide powders of the solid elements are mixed and raised to a temperature of about 1,000°C, driving off volatile materials, such as carbon dioxide. The mixture is reground and reheated, possibly several times to improve the intimacy of the mixture, and then can be pelletized and sintered for up to several hours or more. The sintered pellets can then be annealed at about 400°C and then gradually cooled. Another composition having an approximate unit cell formula of $Y_{1.2}\ Ba_{0.8}\ Cu\ O_4$ has also been of interest. Indeed, a group of compounds generically represented by the formula $(L_wM_x)_vA_yD_z$, particularly where w is equal to 1 - x, has been identified for possible attainment of a superconductive state. L, M, and A are metallic components of the ceramic, whereas D is a non-metallic component such as oxygen. Specific embodiments include not only that in which L is yttrium (i.e. Y), M is barium (i.e. Ba), A is copper (i.e. Cu), D is oxygen (i.e. O), w is 0.6, x is 0.4, v is 2, y is 1, and z is 4 or less, but includes other embodiments such as embodiments where L is lanthanum (i.e. La), embodiments where L is neodymium (i.e. Nd), embodiments where L is samarium (i.e. Sm), embodiments where L is europium (i.e. Eu), embodiments where L is gadolinium (i.e. Gd), embodiments where L is dysprosium (i.e. Dy), embodiments where L is holmium (i.e. Ho), embodiments where L is ytterbium (i.e. Yb), embodiments where L is lutetium (i.e. Lu), embodiments where L comprises scandium (i.e. Sc) and certain embodiments where L is a mixture of these metals, as well as embodiments where M comprises strontium (i.e. Sr), embodiments where M comprises calcium (i.e. Ca), and certain embodiments where M is a mixture of metals selected from barium, strontium, and calcium. Further discussion of such materials is given in M. K. Wu et al. "Superconductivity at 93 K in a New Mixed-Phase Y-Ba-Cu-O Compound System at Ambient Pressure," Physical Review Letters, Vol. 58, No. 9 (1987) and Engler et al., "Superconductivity Above Liquid Nitrogen Temperature: Preparation and Properties of a Family of Perovskite-Based Superconductors," Journal of the American Chemical Society, Vol. 109, pages 2848-2849 (1987).

Pellets have proven convenient for research applications properly involving ceramic superconductive materials since they can be readily formed by pressing together the powdered materials and binding them by a sintering process. These ceramic materials are typically brittle such that they are also more readily handled in pellet form. Where wires are desired, the materials can be bonded to copper in a manner similar to that used previously for the niobium alloy or compound superconductors. However, commercial applications of superconductors are likely to require substantial quantities of such materials in useful shapes such as tubes, rods, wires, or sheets (i.e. shapes where one of its three dimensions differ greatly from the other; i.e., the sheet is thin compared with its dimensions in its plane, and rods, wires, and tubes are long compared with their cross-sectional dimension). Such shapes are difficult to fabricate by pressing powders, and other techniques for conveniently and reliably shaping these ceramic materials while maintaining their ability to conduct electricity with reduced resistance are being sought.

Reportedly, one procedure has been developed in which the ceramic powder is encased in a thin tube of metal such as silver, and then the filled tube is drawn to form a wire. Evaporative techniques have also been reportedly used to produce films of superconducting materials from multiphase material comprising yttrium, barium, copper, and oxygen. In still another procedure the ceramic powder, or even its ingredients, are mixed into an organic fluid such as polyethylene glycol to allow it to be extruded in the form of a wire. After the wire is formed into the desired shape, the binder is burnt off and the residual powders are sintered to form the product filament. Tapes have also been produced by embedding ceramic particles in organic material to produce a flexible tape which can be shaped and then sintered. These techniques represent various approaches to developing methods which can be used for processing superconductive materials, but there remains a demand for alternate means for reliably and conveniently shaping ceramic materials of low electrical resistance. U.S. Patent Application Serial No. 094,179 filed September 4, 1987, is hereby incorporated by reference herein in its entirety, and discloses a method and composition for forming superconducting ceramics and other ceramic materials with reduced electrical resistivity, using certain blends of the ceramic materials (or their precursors) with polymers and plasticizers. In accordance with that patent application, the blend can be shaped by conventional means, the plasticizer can be removed by extraction and/or volatilization, the polymer can be volatilized, and the particles can be sintered to yield the desired ceramic product. Formation of composite ceramic products and products with useful shapes is also disclosed in said patent application.

The conductive performance of the final ceramic material is known to be dependent upon the uniformity of element distribution throughout the composition. A common objective in any of the techniques for formulating and processing superconductive materials is to assure intimate mixing of precursor materials to provide a relatively homogeneous ceramic product. U.S. Patent Application Serial No. 095,083, filed September 11, 1987, is hereby incorporated by reference herein in its entirety, and discloses that superior homogeneity is achieved by reacting certain soluble metal salts with quaternary ammonium carbonates, coprecipitating the metal carbonates, and calcining the precipitate to form a superconducting powder.

## SUMMARY OF THE INVENTION

It has now been found that certain plastic compositions comprising polymer, plasticizer, and particles of superconducting ceramic material, particles of precursors of that ceramic material, or particles of both the ceramic and its precursors, can be conveniently shaped and fired into useful ceramic solid products which exhibit reduced electrical resistivity. During firing the polymer volatilizes, leaving a sintered ceramic solid which exhibits reduced electrical resistivity. The plasticizer is removed by extraction or volatilization prior to sintering. In a particular embodiment disclosed herein, the ceramic materials of this invention are those produced by co-precipitation and calcination of the precipitate. The precursors of this invention include co-precipitate which has not been entirely calcined. The non-ceramic components present at firing are preferably materials which volatilize without producing by-products which chemically reduce the ceramic component during sintering. The plastic compositions can be shaped to useful form, such as rods, tubes, and sheets, prior to firing so that the resulting ceramic product has a desired shape; and the plastic compositions can be bonded prior to firing with another plastic composition containing an insulating ceramic so that the resulting ceramic product has one portion which is superconductive and another portion, integral with the first, which is insulative.

In one embodiment particularly described herein, the plastic composition is bonded prior to firing with a blend of conductive metal particles, polymer, and plasticizer to produce, upon firing, a metal-clad sintered ceramic solid which exhibits superconductivity.

It is an object of this invention to provide a means for producing superconducting ceramic products.

It is another object of this invention to provide a means of shaping superconductive ceramics.

These and other objects of the invention will be evident from the detailed description when taken in conjunction with the accompanying drawing.

## BRIEF DESCRIPTION OF THE DRAWINGS

In the drawings:

Fig. 1 is a perspective view of a tubular product produced in accordance with this invention.

Fig. 2 is a perspective view of a composite bar product produced in accordance with this invention with the core shown longitudinally extended from the jacket for the purpose of facilitating description.

Fig. 3 is a perspective view of a composite sheet product produced in accordance with this invention with the layers shown successively stepped for the purpose of facilitating description.

Fig. 4 is a perspective view of a composite tubular product produced in accordance with this invention with the tubular core shown longitudinally extended from the jacket for the purpose of facilitating description.

## DETAILED DESCRIPTION OF THE INVENTION

Compositions for forming superconducting solids can be formulated in accordance with this invention by blending a polymer, a plasticizer, and particles of a superconducting ceramic material, particles of precursors of said ceramic material, or both particles of said ceramic material and particles of said precursors. Precursors include, for example, the [oxides or carbonates of the metals of the ceramic which can be combined under heated conditions to form the desired ceramic]. While the ceramic materials are those which are superconductive, superconductivity may not be exhibited under all temperature conditions, but may instead be exhibited only within certain temperature ranges. The preferred superconductive materials exhibit superconductivity at the temperatures of liquid nitrogen (about -196° C) or above, where practical applications may more readily be practiced.

Various tests are available for the determination of superconductivity. One of these tests is conventional, simple, and is accepted in the art as definitive. We used two versions of this, the so-called levitation test, in our determinations.

In one version, a circular wafer of the compound is prepared by calcining and compressing as described in Example 1A below. The wafer is about 1-inch in diameter and about 3/16-inch thick. It is placed in the center of a glass dish, and then liquid nitrogen (77° K) is poured into the dish. The wafer bubbles a bit at first, as the nitrogen boils on contact, and as surface air is flushed from the wafer. In a few minutes gas evolution diminishes to nearly zero, and the wafer may be assumed to be chilled to approximately the temperature of the liquid nitrogen. A chip of a rare earth magnet is now dropped gently over the wafer. If the magnet levitates, i.e., hovers above the wafer, the wafer is superconducting. (Comment: Instances have been reported where the magnet sank; yet measurable superconductivity existed and was detectable by more sophisticated means. But a positive test, such as we achieved in our runs, shows certain superconductivity.)

In a second version of the levitation test, the magnet is placed in a ceramic dish. A piece of the ceramic being tested is placed on the magnet in the dish and cooled by the addition of liquid nitrogen to the dish. If the piece of ceramic levitates, the ceramic is considered superconducting.

It is noted that the technology of superconductive materials is rapidly developing, and that it would no longer be surprising if ceramic materials, which are reliably superconductive at room temperature or above, were identified. It is considered that this invention will as well apply to fabricating superconducting solids from particles of such materials.

The components of the compositions can be blended by any conventional manner which will produce a substantially uniform mixture. To produce a particularly uniform mixture, the components can be premixed at room temperature in a blender and the dry blends then can be either fluxed in a conventional mixer, such as a Banbury or Brabender mixer, or melt homogenized in a conventional two-roll mill. When continuous compounding is desired, intermeshing twin screw compounders may be used. An example is the MP compounder manufactured by Baker Perkins Co. and the ZSK compounder manufactured by Werner and Pfleiderer. Preferably, the blend is either extruded, fragmented, and re-extruded or is otherwise compounded by, for example, working it under heated conditions, to further assure that the mixture of

compounds in the composition is uniform.

The proportion of compounds in the composition should be chosen such that the resultant composition is plastic and can be extruded and shaped using conventional plastic technology. In general, these compositions will comprise from about 2 to about 10 weight percent of polymer, about 30 weight percent or less plasticizer, and at least about 60 weight percent ceramic materials, precursors thereof, or both, as essential components. For most blends the plasticizer will comprise at least about 2 weight percent of the composition, preferably at least about 5 weight percent, and the ceramic component (i.e. the ceramic material and/or its precursors) will comprise about 90 weight percent or less.

The polymers suitable for purposes of this invention include materials which, at least in the presence of the plasticizer, can be made fluid at some stage in their processing such that they can be blended in their fluid state with the ceramic and plasticizer components and which can be solidified, preferably at room temperature (i.e. about 20° C), after blending. These polymers are generally non-solvents for the particulate ceramic component of the blend (i.e. the ceramic material and/or its precursors) and are otherwise unreactive therewith such that the particles remain substantially unchanged during blending. Preferably, the polymer has a molecular weight of at least about 100,000 to provide superior binding strength when compounded with the ceramic component. Suitable thermoplastics for carrying out this invention include: unplasticized polyvinyl chloride, polyvinyl chloride-propylene copolymer, polyvinyl, chloride-ethylene copolymers, polyvinylidene chloride and its copolymers, polystyrene, impact styrene, ABS resin, styrene butadiene block copolymers, polyethylene low (0.91 sp. gr.) to high density (0.965 sp. gr.), polyethylene copolymers with propylene, butene, 1-pentane, 1-octane, hexene, styrene, etc., polyethylene copolymers with vinyl acetate, alkyl acrylate, sodium acrylate, acrylic acid, etc., chlorinated polyethylene, chlorosulfonated polyethylene, polypropylene and propylene-olefin copolymers, polybutene and butylene-olefin copolymers, poly 4-methyl 1-pentene, thermoplastic polyurethanes, polyamides, e.g. Nylon 5, Nylon 12, Nylon 6/6, Nylon 6/10, Nylon 11, fluorocarbon resins such as FEP, polyvinylidene fluoride, polychlorotrifluoroethylene; acrylonitrile-methyl acrylate copolymers, acrylonitrile - vinyl chloride copolymers, methacrylonitrile-styrene copolymers, polymethyl methacrylate, cellulose acetate, cellulose acetate butyrate, acetal, polycarbonate, polysulfone, polyphenylene oxide, polyethylene and butylene terephthalate polymers.

While thermoplastics are preferred because they may more readily be made fluid for blending and solidified by respectively raising and lowering the temperature of the polymer, and may be more readily re-extruded, or otherwise post-formed after mixing, some thermosetting resins and crosslinkable resins may be suitable for purposes of this invention, including the following: radiation cured polyethylene, peroxide-cured polyethylene, diazo crosslinked polypropylene, epoxy resins; hydrocarbon, chloroprene, and nitrile rubbers, furane, melamine-formaldehyde, urea-formaldehyde, phenol-formaldehyde, diallyl phthalate, polyesters and silicones.

From economic considerations, one wishes to use relatively inexpensive binder polymers since they will be burned away in the final product. A preferred group of polymers are polyolefins, polyvinyl acetates, polystyrenes and any mixture of these polymers, with polyolefins such as polyethylene being considered a most preferred group. Indeed, polyethylene having a molecular weight between about 100,000 and about 5,000,000, especially between about 250,000 and about 2,000,000, is considered particularly suitable because of its low cost, ease of processing with plasticizers, and environmentally acceptable degradation products.

The preferred polyolefins (which may be a mixture) have a high molecular weight (i.e., a molecular weight of at least 100,000, preferably a molecular weight of 150,000 or more, and most preferably, a molecular weight of 300,000 or above). Preferably, the polyolefin has a standard load melt index of substantially 0 and a reduced solution viscosity of about 4.0, or more. Suitably, the polyolefin is a linear polyethylene of at least 0.93 to about 0.96 grams per cubic centimeter (i.e. g/cm$^3$) density; high molecular weight polypropylene; or high molecular weight particle form ethylene-butylene co-polymer. Others are polybutene, ethylene-propylene co-polymers, ethylene-butene copolymers, propylene-butene copolymers, and ethylene-propylene-butene copolymers. Especially useful are polyolefins selected from the group consisting of high molecular weight particle form high density (0.93-0.96) polyethylene, high molecular weight low density polyethylene, high molecular weight polypropylene, and high molecular weight particle form ethylene-butylene copolymer. One such useful polyolefin is a commercial particle form high molecular weight polyethylene having a standard load (2,160 g.) melt index of about 0.0; a high load (21,600 g.) melt index of 1.8 (both at 190° C), a density of 0.96, and a solution viscosity of 4.0 measured as 0.02 gram of polymer in 100 g. decalin at 130° C.

Blends of high and low molecular weight polyolefins can be used, bearing in mind that as the average molecular weight is reduced, the possibility of distortion (slumping) is increased during the early part of the firing process.

Suitable polyolefins include FD 60-018 polyethylene,. available commercially from Allied Chemical Corp., and an ultra-high molecular weight linear polyethylene available as "GUR-412" from American Hoechst Corp. (the molecular weight of the latter reportedly exceeds 1 million).

Compositions blended in accordance with this invention include a plasticizer for the polymer component, which at elevated temperature (typically between about 90°C and about 200°C), interacts with the polymer to provide a fluid combination having a lower viscosity than the polymer itself, thus facilitating the mixing of the polymer with the solid, particulate ceramic material or precursors thereof. In other words, the presence of plasticizer improves the processibility of the blend by reducing the amount of power which is required to compound and fabricate the composition. Generally, the plasticizer used should plasticize the polymer at the compounding temperature, and preferably has a volatilization temperature lower than that of the polymer so that plasticizer which is not extracted prior to firing will volatilize before the polymer volatilizes. Other aspects of the invention described herein are also often attributable to use of the plasticizer component. For example, the plasticizer generally provides blended compositions which may be more easily shaped and which are more impact resistant. As more fully discussed hereinafter, the plasticizer also represents a material which can be relatively easily extracted from the composition to provide more rigidly shaped compositions, and to provide the compositions with a porosity that facilitates the escape of gaseous products which are produced when the polymer is heated and volatilized. The final porosity of the ceramic product with reduced electrical resistivity produced in accordance with this invention is also related, at least in part, to the plasticizer of the blended composition.

The plasticizer component can be soluble or insoluble in water, and may be almost any of numerous commonly used plasticizers, including mixtures thereof. For example, suitable water-soluble plasticizers include glycol compounds such as glycol ethers and esters, as well as glycol itself; glycerin compounds such as glycerin itself and glycerol and ethers and esters thereof, including glycerol monoacetate; alkylene glycol compounds such as trimethylene glycol, tetramethylene glycol, ethylene glycol, diethylene glycol and ethers and esters thereof, triethylene glycol, polyethylene glycols (preferably those within a molecular weight range of from about 400 to about 20,000), propylene glycol, dipropylene glycol, polypropylene glycol (preferably within a molecular weight range of from about 260 to about 1200), and 2,3-butylene glycol; alkyl phosphate compounds such as triethyl phosphate; and water-soluble polymeric plasticizers such as polyvinyl alcohol, partially hydrolyzed polyvinyl acetate, polyacrylic acid and polyvinyl pyrrolidone. Suitable organic solvent soluble plasticizers include, for example, organic esters such as sebacates, phthalates, stearates, adipates, and citrates; epoxy compounds such as epoxidized vegetable oil; phosphate esters such as tricresyl phosphate; hydrocarbon materials such as paraffin oil, mineral oil, petroleum oil including lubricants, oils and fuel oils, hydrocarbon resin, and pure compounds such as eicosane; low molecular weight polymers such as polyisobutylene, polybutadiene, polystyrene, atactic polypropylene, ethylene-propylene rubber, ethylene-vinyl acetate copolymer, oxidized polyethylene, coumarone-indene resins, and terpene resins; oils such as tall oil and linseed oil; chlorinated hydrocarbons; sulfonamide; and asphalt. Mixtures of water-soluble plasticizers and organic solvent plasticizers may be included. Like the polymer, the plasticizer component is generally unreactive with the particulate ceramic component of the blend such that the particles remain substantially unchanged during blending.

The plasticizer is one that can be removed from the blend of ceramic material, polymer, and plasticizer by extraction or by volatilization, and is preferably selected from the group consisting of mineral oil, diethylene glycol, propylene glycol, dipropylene glycol, glycerin, glycerol monoacetate, trimethylene glycol, tetramethylene glycol, 2,3-butylene glycol, triethyl phosphate, polyvinyl alcohol, and polyvinyl pyrrolidone. Mineral oil has proven especially suitable, particularly when polyolefin polymers such as polyethylene are used as the polymer component.

The ceramic materials include those selected from the group of materials which are known to exhibit superconductivity at temperatures of liquid nitrogen or higher, such as those having the formula $Y\ Ba_{1.67x}\ Cu_{0.83y}\ O_{0.83z}$ where 1.67x, 0.83y, and 0.83z respectively, represent the amounts of barium, copper, and oxygen in the material relative to the amount of yttrium therein. In one embodiment x is about 1.2, y is about 3.6 and z is about 8.4; and in another embodiment x is about 0.4, y is about 1 and z is about 4. These ceramic materials may be prepared from suitable precursors of such ceramics, such as the pure metals themselves and their oxides, carbonates, and other compounds which upon firing in an oxygen-containing atmosphere, will yield the metal oxide of the metals used in the ceramics. As disclosed herein, the ceramic materials of a preferred embodiment may be prepared in accordance with this invention by a process comprising the steps of providing an aqueous solution of yttrium nitrate, barium nitrate, and copper nitrate with yttrium, barium, and copper in the desired atomic ratio (eg. 1:2:3); mixing the solution of nitrates with a solution of certain quaternary ammonium carbonates to produce a carbonate slurry of co-precipitate; recovering the co-precipitate from the slurry; and calcining the co-precipitate to produce a superconducting

powder of yttrium, barium, copper, and oxygen. However, useful embodiments of this invention are also conveniently prepared from suitable precursors of such ceramic materials, such as the dried coprecipitate from the slurry, and a product produced by heating the dried co-precipitate to a temperature sufficient to decompose or otherwise volatilize any remaining quaternary ammonium and nitrate material and to achieve partial conversion of carbonates in the co-precipitate to oxides. These precursors, upon firing in an oxygen-containing atmosphere, will yield the metal oxide of the metals used in the ceramics. In other words, suitable precursors are those which, upon heating, lose their extraneous components through volatilization so that the remaining components can combine to form the desired ceramic material. For example, a ceramic composition having the unit cell formula $Y\ Ba_2\ Cu_3\ O_z$ may be prepared by using particles of $Y\ Ba_2\ Cu_3\ O_z$, by using precursor particles of the above-referenced co-precipitate with Y, Ba, and Cu in an atomic ratio of about 1:2:3 respectively, or by using mixtures of $Y\ Ba_2\ Cu_3\ O_z$ particles with precursor particles.

Other ceramic metal oxide superconductors and their precursors are also considered suitable for use in this invention: for example, ceramic materials having superconductivity and the more general formula $(L_wM_x)_vA_yD_z$ where L, M, and A are metallic components of the ceramic and D is non-metallic component such as oxygen, and w, x, v, y, and z define the relative proportions of the components. Preferably, L is at least one trivalent metal (i.e. valence of +3) such as yttrium or bismuth, and is most preferably selected from Y, Sc, and the other rare earth elements with atomic numbers 57-71. Preferably, M is at least one bivalent metal (i.e. valence of +2) such as Ba or Sr, and is most preferably selected from the group Ba, beryllium (i.e. Be), magnesium (i.e. Mg), Ca, and Sr. Preferably, A is at least one metal of multiple valency (i.e. more than one valence state) such as niobium or copper, and is most preferably selected from the group silver (i.e. Ag), gold (i.e. Au), and Cu; and D is oxygen. Suitable ceramic materials include those disclosed in U.S. Patent Application Serial No. 095,083, filed September 11, 1987. A preferred formulation uses Y, Ba, and Cu in an atomic ratio of 1:2:3. This results in an amount of oxygen in the calcined product equal to about 7 (or a little less) atoms per atom of Y.

In preparing the ceramic materials by co-precipitation, an aqueous solution of the L.M.A. metal salts is made up by dissolving their nitrates or other water-soluble salts in water, so as to provide the predetermined L.M.A. atomic ratio for the superconductor (eg. yttrium nitrate, barium nitrate, and copper nitrate may be dissolved in water so that the yttrium, barium, and copper ions are present in the solution in a ratio of substantially 1:2:3).

A solution of quaternary ammonium carbonate is also prepared. This may be conveniently accomplished by bubbling $CO_2$, through an aqueous solution of a quaternary ammonium hydroxide until the quaternary carbonate is stoichiometrically formed and $CO_2$ is dissolved in excess. The preferred quaternary ammonium hydroxides have the formula:

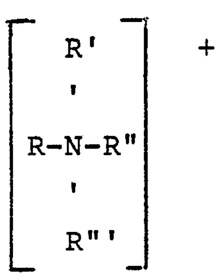

$-OH^-$, where R, R', R", R"' are the

same or different members of the group

i) alkyl, e.g., tetramethylammonium hydroxide, tetraethylammonium hydroxide, tetrapropylammonium hydroxide, dimethyldiethylammonium hydroxide, cyclopropyltrimethylammonium hydroxide and the like;

ii) aromatic, e.g., phenyltrimethylammonium hydroxide, phenylethyldimethylammonium hydroxide, benzyltrimethylammonium hydroxide, and the like;

iii) heterocyclic;

iv) and any two group members may be joined in a ring whereby N becomes a ring member, e.g., dimethyl pyrrolidinium hydroxide, dimethylpyridinium hydroxide, and the like.

Said solutions of L.M.A. metal salts and quaternary ammonium carbonate are then both added slowly, simultaneously, at constant rates, with stirring, to a pool ("heel") of deionized water. This pool is the reaction medium for the carbonate co-precipitation reaction, and the eventual result is a carbonate slurry. The two solutions and the heel are suitably each about the same starting volume. The pH should be maintained at about 7.5 or above, suitably between 7.5 and 12, during co-precipitation. For example, the pH

of the reaction mass may be maintained at about 7.7-8.0 by drip-wise addition of a quaternary ammonium hydroxide. The precipitated carbonates can be recovered from the slurry using various techniques. On a laboratory scale simple filtration followed by air drying the precipitate is adequate for good homogeneity.

When the carbonate precipitation is complete, the resulting slurry consists essentially of

i) L.M.A. carbonates, about 0.5-75 wt%;

ii) quaternary ammonium cations about 0.1-75 wt%;

iii) anions residual from the starting L.M.A. salts, stoichiometrically equivalent to the L.M.A. carbonates; and

iv) balance, water.

The filtered and air-dried precipitate recovered from this slurry is generally friable and easily crumbled. It is thus suitable for forming precursor particles.

To form superconductor from the carbonate precipitate, we calcine according to the the following program:

1) The precipitate is placed in an alumina boat, which is then placed in an electric furnace, in flowing air.

2) The furnace is brought up to about 600°C to 1400°C, the precise calcining temperature range depending upon the metal composition. Generally, the preferred temperature range is from about 850°-1050°C, suitably 950°. The time required to bring the furnace up to temperature is not critical. At least a few minutes is, however, generally necessary, depending on the structure and operation of the furnace.

3) The furnace is maintained at the temperature selected in 2) for about 4-8 hours, suitably about 6 hours.

4) Next, the furnace is gradually cooled over a period of time (linear cooling). This step is important. We prefer to cool down to about room temperature to 250°C over 5-12 hours, suitably 8 hours. Cooling is preferably accomplished in an atmosphere of $O_2$.

At this stage the calcined product - a powder - is superconducting. To facilitate the levitation test, it may be compressed into a wafer.

In general, a superconducting ceramic product produced in this manner shows a relatively narrow $\Delta T_c$, indicating a high degree of purity and homogeneity. By "Delta $T_c$" we mean the width of the resistivity. curve as it leaves the zero resistivity line at some particular temperature, $T_c$ rises (generally sharply) with rising temperature (indicating increasing resistivity and loss of superconductivity) and then levels off asymptotically at another particular temperature, indicating complete or substantially complete loss of superconductivity and entry of the ceramic into the world of normal resistance/conductivity.

Precursors for such superconducting ceramics are also considered suitable. As noted above, suitable precursors include the dried, uncalcined co-precipitate. However, we have found that a useful organic-free precursor can be prepared by heating the dried co-precipitate. recovered from the co-carbonate slurry to a temperature sufficient to decompose or otherwise volatilize any remaining quaternary ammonium and nitrate material, and to achieve partial conversion of the carbonates in the co-precipitate to oxides. For example, an yttrium-barium-copper co-precipitate from nitrate salts may be heated to about 540°C to remove quaternary ammonium and nitrate material and to convert yttrium and copper carbonates to their respective oxides. These intermediates are generally powders which can be conveniently stored, shipped, or processed and can be easily transformed to superconductors by the calcination procedure as described above. In any case, superconducting ceramic material and precursors may be prepared using co-precipitation.

In one group of ceramic materials having the general formula $(L_wM_x)_vA_yD_z$, w is equal to 1 - x, and a specific chemical compound system has been identified where x is 0.4, v is 2, y is 1, and z is about 4 or less. As suggested above, this system includes the embodiment where L is yttrium, M is barium, A is copper, and D is oxygen. Additional ceramic compositions in which L is selected from the group of metals consisting of La, Nd, Sm, Eu, Gd, Dy, Ho, Yb, Lu, Sc as well as Y, and where M is selected from the group of metals consisting of Sr, Ca as well as Ba, and which exhibit reduced electrical resisistivity, are mentioned as other examples. Reportedly, superconductivity has been observed not only in the above-referenced Y-Ba-Cu-O ceramics, but also in other ceramics such as those having the formulas $NdBa_2Cu_3O_z$, $SmBa_2Cu_3O_z$, $EuBa_2Cu_3O_z$, $GdBa_2Cu_3O_z$, $DyBa_2Cu_3O_z$, $HoBa_2Cu_3O_z$, $YbBa_2Cu_3O_z$, $LuBa_2Cu_3O_z$, $Y_{0.5}Sc_{0.5}Ba_2Cu_3O_z$, $Y_{0.5}La_{0.5}Ba_2Cu_3O_z$, $Y_{0.5}Lu_{0.5}Ba_2Cu_3O_z$, $YSrCaCu_3O_z$, $YBaSrCu_3O_z$, $YBaCaCu_3O_z$, $YbBaSrCu_3O_z$, and $YbBaCaCu_3O_z$, where z is about 7.

The ceramic materials and/or their precursors should be provided as particles which are small enough for convenient mixing. For ceramic materials or their precursors, 100 mesh or smaller is generally preferable (i.e., particles sized to pass through 149 micron sieve openings).

Some conventional processes enhance homogeneity by grinding calcined superconductor, followed by recalcining. In some instances this sequence may be repeated several times. It is known that improved

homogeneity in the general case enhances superconductivity. The problem here is that effective grinding inevitably and inherently introduces trace impurities into the ceramic, simply by impacting the ceramic between the balls and walls (or other grinding surfaces) of the grinding mill. It is known, for example, that silica or stainless steel balls in a ball mill lose significant mass over a period of use. This mass of course disappears into whatever was being milled. Mills that comminute by particle self-impact lose metal by wall-scouring, particularly in the area of stream entry.

Thus, the firing-grinding-refiring technique rapidly achieves a balance: improvement in homogeneity tends to be matched by contamination build-up that cancels part or all of the improvement.

Use of co-precipitation as described herein to produce superconductor powders or their precursors, by achieving ultimate homogeneity in the first place, avoids the grinding problem altogether. This product can, of course, be subjected to the conventional firing-grinding-refiring cycle, but this is not our preferred technique. The process works best, and our best superconductors are obtained, when no extraneous materials (other than those which can be volatilized during calcination and firing) are introduced into the co-precipitated material at any stage. "Extraneous materials" include materials introduced into the base metal solution to precipitate the carbonates, e.g., potassium carbonate to precipitate Y, Ba, and Cu carbonates. The term also includes contaminants (generally metals or metal oxides) introduced into the composition by grinding the L.M.A.D. composite. If the product is ground in a ball mill using quartz or silica balls, some of the impurity is silica.

When certain precursors are used, there is an additional consideration that the particles should be small enough to allow sufficient interaction between the various precursors during sintering to provide the desired ceramic product. The particle size of precursors is thus most preferably 200 mesh or smaller (i.e., particles sized to pass through 74 micron sieve openings). These smaller particle sizes may of course also be used advantageously when ceramic materials are used within the composition. It is well known to those skilled in the art of sintering that the factors affecting sintered product properties include particle size as well as sintering conditions. However, particles which result in high surface area per gram may require the use of high amounts of non-ceramic material for processing, and accordingly, would result in a more porous product. Powders with bimodal size distribution can also be used with advantage to facilitate processing and shaping. This is believed to be attributable to the interplay of the particles of different size during fluid movement.

It is conventional to add stabilizers (antioxidants) and lubricants when fabricating materials containing polymers such as polyolefins. Such additives and the amounts and manner of their use are well-known in the art. Representative of the stabilizers are 4,4 thiobis (6-tert-butyl-m-cresol) ("Santonox") and 2,6-di-tert-butyl-4-methylphenol ("Ionol"). The stabilizers and lubricants chosen should be those which can be burnt off during firing. Indeed it is preferable to avoid all components other than the desired ceramics and their precursors, which will not volatilize before the sintering temperature is reached. "Volatilize" as used herein denotes a conversion to gas or vapor, and, particularly for high molecular weight or gaseous materials such as polymers, includes decomposition to smaller molecular weight materials. Thus, while zinc stearate is a good lubricant in a 0.5% concentration, other lubricants such as stearic acid are preferred to avoid contamination of the finished ceramic product with such materials as zinc or zinc oxide.

The above-described plastic compositions can be used to form solids with reduced electrical resistance by shaping them as desired, optionally extracting at least part of the plasticizer with a solvent, and then heating the composition first to a temperature of at least the volatilization temperature for the plasticizer, typically between about 100 degrees Celcius (i.e. °C) and the boiling point of the plasticizer, then to a temperature suitable to volatilize the polymer and any remaining plasticizer, typically between about 500°C and about 700°C, followed by firing at a higher temperature sufficient to sinter the specific ceramic materials, typically at least about 900°C, without volatilizing them. While certain ceramics may be sintered at temperatures up to about 1600°C, many ceramic components of this invention are most suitably sintered at temperatures of about 1100°C or less, often about 1000°C or less. Sintering is preferably continued for from about 1 to about 6 hours to provide a rigid monolithic ceramic structure which exhibits the superconductivity desired. Where precursor particles are used, the method of this invention allows them to react during sintering to form the desired superconducting ceramic. For example, it will be evident that calcination of precursors produced using the co-precipitation step described herein can be accomplished during the firing process. It will be evident to one skilled in the art of sintering that the temperature and time of sintering both affect the morphology of a ceramic product, and that the sintering conditions should be controlled to prevent decomposition, vaporization, melting or undesirable grain growth. It is preferable to slowly cool the resultant monolithic ceramic structure over a period of up to 24 hours to provide some annealing, and specific annealing temperatures may be maintained for several hours. Inasmuch as combustion of the polymer and/or plasticizer can consume considerable oxygen, oxygen must be available

during firing to prevent oxygen deficiency within the final product. Indeed, substantial chemical reduction of the ceramic material during firing can prevent development of the desired electrical properties. Accordingly, the non-ceramic components present at firing are preferably materials which volatilize without producing significant amounts of carbon residue or other by-products which can undesirably reduce the ceramic component during firing. For example, the polyolefins are known to volatilize by degrading without producing carbonaceous residue which could reduce the ceramic component as it sinters. On the other hand, certain acrylic polymers produce carbon fibers upon heating, and thus would be less desirable in the present invention.

The shaping step may be accomplished by various standard thermoplastic forming processes. For example, pellets or granules of the plastic composition can be compression molded, extruded, or injection molded. The material can also be subjected to a combination of mechanical shaping methods. For example, a sheet can be extruded, and then stamped, punched, or cut into desirable shapes. Any material waste from these shaping processes can usually be recycled. Continuous shaping operations can be combined with mixing the components, when continuous compounding equipment is used.

Firing of the compositions may be accomplished in conventional kilns. It may comprise two distinct steps of heating the composition to a temperature where the non-ceramic components such as the polymer and unremoved plasticizer are volatilized, and then raising the temperature to achieve sintering. Alternatively the firing may comprise gradually raising the temperature of the composition to the sintering temperature such that volatilization can occur during the heating process. In any case, the resulting composition may be somewhat porous and will be in general somewhat shrunken due to the loss of material during volatilization and densification during sintering. It is possible that the porosity of the products produced in accordance with this invention, especially where the sintering time is short, might be considered undesireable for certain applications. On the other hand, porosity may be considered advantageous where intimate contact between the solid ceramic and a fluid environment is desired. In any case, porosity may be reduced by sintering for longer periods, say from 2 to 24 hours, the reduction of porosity being accompanied by additional shrinkage. It is also considered feasible to reduce the shrinkage by using metals rather than their oxides or carbonates as precursors, and by sintering in an oxygenated environment such that oxygen is taken up during the sintering process. For example, metallic copper rather than copper oxide could be used as a component of a composition blended in accordance with this invention. In any case, where products comprising oxide-containing ceramic materials are desired, it is preferred to sinter in an oxygenated environment to facilitate formation of those ceramics. Indeed, the amount of oxygen in the final ceramic material is dependent somewhat upon the environment in which sintering takes place.

The production of superconducting ceramic material in accordance with this invention will become further apparent from the following non-limiting example.

## EXAMPLE 1A

Carbon dioxide (from dry ice) was bubbled through 0.405 moles of 40 wt% tetraethylammonium (TEA) hydroxide until the pH was 8.3 to form $TEA_2CO_3$ and/or $TEAHCO_3$. The solution was diluted to 250 cc. 0.016 moles yttrium nitrate, 0.032 moles barium nitrate, and 0.048 moles copper nitrate were dissolved in deionized water to make 250 cc solution. The two solutions were slowly dripped into a heel of 300 cc deionized water with stirring. The pH was maintained at about 7.7-8.0 by the dropwise addition of a solution of TEAOH (40 wt%). The TEAOH solution had a pH of 14-15. The light blue precipitate was filtered, then dried at 110°C overnight and fired in flowing air. The firing program involved a ramp to 950°C over 6 hours, maintaining 950°C for 6 hours, then linearly cooling to 150°C over 8 hours. The resulting black solid, when compressed (180001bf, 3/4"-diameter die) into a wafer, could levitate a magnet at liquid nitrogen temperatures.

Products produced in accordance width this invention will become further apparent from the following non-limiting examples.

## EXAMPLE 2A

A powder prepared using the general procedure of Example 1A (but at a larger scale using tetramethyl ammonium hydroxide (TMA) as the quaternary ammonium compound and cooling under oxygen following

calcination in air at about 920° C) was mixed with polyethylene (in particular, GUR 412, available from American Hoechst and having a molecular weight believed to be about 2,000,000) and mineral oil (in particular, Sunthene 255, available from Sun Chemical). The mixture was compounded twice using a roller-head mixer (Haake Rheocord) set at 150° C and 50 rpm. The resulting composition was about 82.3 weight percent powder, about 2.9 weight percent polyethylene, and about 14.8 weight percent oil. A portion of this composition was shaped by extrusion at about 150° C, using a small ram extruder, into rods. The oil was then extracted from the rods by immersion in hexane and the resultant material was dried by evaporation at room temperature. The rods were then gradually heated to 700° C over two hours, fired for five hours at 700° C, and heated to 950° C over one hour such that the polymer and remaining plasticizer were volatilized before the sintering temperature was reached. The ceramic rod was then respectively fired for ten hours at 950° C, cooled to 650° C over three hours (in oxygen), cooled to 450° C over six hours (in oxygen), and then allowed to cool to room temperature (in oxygen). The ceramic rods which resulted, when cooled in liquid nitrogen above a permanent magnet, showed levitation. Particularly impressive was an approximately one-eighth inch long piece of rod (about one thirty-second of an inch in diameter) which, when placed on a magnet and then cooled, was violently ejected off the magnet.

## EXAMPLE 3A

A portion of the compounded powder-polyethylene-oil composition formed in Example 2A was pressed into flat sheets (about 0.025 inches thick) using a hydraulic press with heated platens (about 150° C). The oil was then extracted from the sheet by immersion in hexane and the resultant material was dried by evaporation at room temperature. The sheets were then gradually heated to 700° C over two hours, fired for five hours at 700° C, and heated to 950° C over one hour such that the polymer and remaining plasticizer were volatilized before the sintering temperature was reached. The ceramic sheet was then respectively fired for ten hours at 950° C, cooled to 650° C over three hours (in oxygen), cooled to 450° C over six hours (in oxygen), and then allowed to cool to room temperature (in oxygen). The ceramic sheets which resulted, when cooled in liquid nitrogen above a permanent magnet, showed levitation.

While the following non-limiting examples 1B, 2B, and 3B did not employ the co-precipitated ceramic materials described herein, it is believed that such ceramic superconductors and/or precursors may be used in a manner similar to that of the conducting ceramic or precursors exemplified to produce superconducting products.

## EXAMPLE 1B

36.3 grams of $Y_2O_3$, 42.4 grams of $BaCO_3$, and 21.3 grams of CuO were screened through a 200 mesh screen and compounded with 5.0 grams of polyethylene (in particular, GUR 412) and 20.0 grams of mineral oil. The resulting composition was shaped by extrusion at about 150° C, using a meltindexer, into a rod approximately 2.5 millimeters ("mm") in diameter and approximately 32 mm long. The oil was extracted by immersion in 1,1,1-trichloroethane and the resultant material was dried by evaporation at room temperature and then was gradually heated to 1000° C over 4 hours such that the polymer and remaining plasticizer was volatilized before the sintering temperature was reached. The ceramic rod was sintered at about 1,000° C for 6 hours, and then cooled over 2 hours to room temperature. The ceramic rod which resulted exhibited an electrical resistance of about 2.2 ohms at room temperature (i.e., about 22° C) as calculated from voltage and current measurements obtained using conventional meters. When immersed in liquid nitrogen, however, the electrical resistance of the rod was reduced to 0.23 ohms.

## EXAMPLE 2B

46.2 grams of $Y_2O_3$ and 53.8 grams of $BaCO_3$ were compounded with 5.0 grams of polyethylene and 20.0 grams of oil. 30 grams of this composition was then further compounded with 8.5 grams of copper metal powder. The resulting composition was extruded to rod shape, extracted and sintered. The ceramic product which resulted appeared by color to be equal to products prepared using CuO as in Example 1B.

EXAMPLE 3B

A 30 cm long, 2.5 mm dia. rod was extruded from the composition of Example I and was shaped into a coil shape as extruded. After cooling, the oil was extracted and the coil sintered at 1,000° C as in Example 1B, to produce a ceramic coil of sufficient integrity to be handled. The coil was brittle as most ceramics are.

While the plastic composition of this invention should be shaped into final form prior to firing, it is not necessary that the composition be shaped immediately prior to firing. Indeed, plastic compositions of particularly useful shapes may be prepared in accordance with this invention, and then stored and shipped in plastic form until production of rigid products are desired. For example, sheets of a plastic composition comprising polyethylene, mineral oil, and ceramic may be extruded using a screw extruder equipped with a sheet-forming die and having a 20:1 length to diameter ratio and a 3:1 compression ratio. The sheet may be extruded at a temperature of from about 300° F and about 500° F in a thickness of from about 10 to about 75 mils and a width of from about 4 to about 40 inches. The cooled sheet may then be stored in its plastic form, either in its extruded form or after further shaping (for example, cutting), until extraction and sintering is desired.

If final shapes are formed, it may be desirable to reduce the plasticity of the composition to inhibit further deformation during handling and storage. This can be done by extracting at least part of the plasticizer after shaping, but prior to storage and handling, using a volatile solvent for the plasticizer which is not an effective solvent for the ceramic material or the polymer. For example, where mineral oil is used as the plasticizer, hexane can be used for extraction. Even where unwanted deformation during storage and handling is not a consideration, extraction of at least part of the plasticizer may be necessary in some applications to prevent slumping of the shaped material as it is being heated to burn off the polymer and remaining plasticizer. In any case, the shaped material is preferably dried following extraction of the plasticizer. This can generally be accomplished simply by allowing the residual solvent to evaporate at room temperature and can be expedited by raising the temperature and/or applying a vacuum.

One consideration in producing a product which exhibits electrical conductivity is providing for its electrical insulation. It is also known that certain ceramic materials exhibit reduced electrical resisitivity or superconductivity only at low temperatures. "Low temperatures" as used in this context means below room temperatures. Two other considerations associated with producing products which exhibit reduced electrical resistivity only at low temperatures involve providing for cooling of the conducting material, and providing for thermal insulation of the products. The instant invention can be used to provide products which especially address one or more of these considerations, as well as compositions especially suitable for conveniently producing such products.

One group of products includes channelized products such as the tube of superconducting ceramic material, illustrated at (10) of Fig. 1, wherein the channel provides a conduit for circulating fluid coolants. Thus, when the solid elements of the product such as tube wall (12) exhibit the desired reduced electrical resistance only when maintained at low temperatures, coolant may be circulated within the channels such as tube channel (14). Coolant may, of course, also be circulated past the outer surface (18) of the tube as allowed by the particular application and design. Where the porosity of the ceramic material allows for coolant flow through the tube walls, it will be evident that the expected fluid flow rate through the tube channels should be adjusted to account for any gain or loss of coolant through the walls. Further, the resultant evaporation of the coolant (for instance, liquid nitrogen) from the surface of the tube will aid in keeping that surface at low temperature. Alternatively, the pores could be sealed with a suitable coating.

It is noted, without limiting the invention to a particular theory of operation, that some skilled artisans have suggested that the conductivity of superconductors take place primarily along the surfaces of the conductor, with the interior of the conductor being relatively inert. Thus, in addition to providing a channel for a cooling liquid, use of superconductors in tubular form will consume less material, without lowering the surface area.

A tube such as that illustrated in Fig. 1 can be conveniently produced by blending a polymer, plasticizer, and ceramic material in accordance with this invention and extruding it through a conventional extruder fitted with a tube die. The extruded tube represents a conveniently shaped composition because it can be fired with or without prior extraction of the plasticizer, and sintered to form a ceramic tube which is adapted for direct cooling.

This group of products produced in accordance with this invention will become further apparent from the following non-limiting example.

EXAMPLE 4A

A portion of the compounded powder-polyethylene-oil composition formed in Example 2A was shaped by extrusion at about 150° C using a small ram extruder equipped with a tubing die. The oil was then extracted from the tube by immersion in hexane and the resultant material was dried by evaporation at room temperature. The tubes were then gradually heated to 700° C over two hours, fired for five hours at 700° C, and heated to 950° C over one hour such that the polymer and remaining plasticizer were volatilized before the sintering temperature was reached. The ceramic tube was then respectively fired for ten hours at 950° C, cooled to 650° C over three hours (in oxygen), cooled to 450° C over six hours (in oxygen), and then allowed to cool to room temperature (in oxygen). The ceramic tubes which resulted, when cooled in liquid nitrogen above a permanent magnet, showed levitation.

While the following non-limiting example 4B did not employ the co-precipitated ceramic materials described herein, it is believed that such ceramic superconductors and/or precursors of this application may be used in a manner similar to that of the conducting ceramic or precursors exemplified to produce superconducting products.

EXAMPLE 4B

The meltindexer was equipped with a die for extrusion of 1/8" diameter tubing. The plastic composition of Example 1B was extruded through the tube die and the resulting tubing was shaped into a coil. The oil was then extracted and the hardened coil was heated and sintered at 1,000° C. The resulting product represented a ceramic coil of tubing having four turns of 1" diameter.

Another group of products includes insulated products such as the insulated bar of superconducting material which can be illustrated by (20) of Fig. 2, wherein a ceramic dielectric (insulator) provides electrical insulation for the conducting material. Many dielectric ceramics also act as thermal insulators. Thus, when it is desirable to provide electrical insulation for the conducting elements of the product such as superconducting cylindrical core (22) which might otherwise be exposed to electrical intereference, it is advantageous to provide a ceramic insulator, such as the dielectric annular jacket shown at (26) in Fig. 2, to provide electrical insulation for the core (22). It will be evident that multiple cores may be embedded in and insulated by the same jacket. It will also be evident that rods or tubes containing more than two layers of compositions can be produced using conventional technology.

A composite bar such as that illustrated in Fig. 2 can be conveniently produced by blending a polymer, plasticizer, and ceramic material in accordance with this invention and extruding it through a conventional extruder fitted with an appropriate rod die. A second composition comprising a polymer, plasticizer, and another, dielectric ceramic such as aluminum oxide or cordierite may be similarly blended and extruded through a tube die sized such that after extrusion the rod with the conducting ceramic (or precursor) can be inserted within the channel of the tube with dielectric ceramics. This composite can be fed into a ram extruder and re-extruded as a bar composite with the two portions firmly bonded together. Alternatively, one or more rods of ceramic with reduced electrical conductivity (or its precursors) can be coextruded by conventional means in the presence of additional feed consisting of the second composition with dielectric ceramic. In any case, such a composite bar represents a conveniently produced and shaped composition because it can be shaped and fired, with or without prior extraction of the plasticizer(s), and sintered to form a ceramic bar having a conducting core and an insulating jacket integral with the core. For example, one particular application might be to coil the composite bar in its plastic form such that the product which results after firing and sintering (i.e. a conductor with insulation) is suitable for electromagnetic applications.

While the following non-limiting example 5B did not employ the co-precipitated ceramic materials described herein, it is believed that such ceramic materials and/or precursors of this application may be used in a manner similar to that of the conducting ceramic or precursors exemplified to produce superconducting products.

## EXAMPLE 5B

A composition of $Y_2O_3$, $BaCO_3$, CuO, polyethylene and oil was formed as in Example 1B and was extruded into a 2.5 mm rod of 5 cm length.

Separately, polyethylene, oil, aluminum, silica, and magnesia were compounded to form a composition known to yield after sintering a ceramic insulator (i.e. a cordierite). The composition, known to provide electrical insulation, was shaped into a sheet of about 1 mm thickness, and this sheet containing insulating ceramic precursors was wrapped around the rod containing the superconductor precursors to produce a cylindrical charge, about 9 mm in diameter. This charge was inserted into the meltindexer, heated, and extruded to a new 2.5 mm rod. The new rod contained the superconductor precursor composition in the center, surrounded by the insulating ceramic precursor composition. After extraction of the oil from this coextruded composite rod, the rod was sintered to 1,200 °C. The resulting product represented a ceramic composite having a core of conductor materials consisting essentially of yttrium, barium, copper, and oxygen and a surrounding jacket of insulator materials.

It is noted that the compositions of this invention can be conveniently fired because extraction and/or volatilization of the plasticizer and volatilization of the polymer creates pores which allow avenues of escape for the gaseous products of further volatilization. One particular embodiment of a composite product such as bar 20 would provide for the composition at the outer portion such as the annular jacket (26), to comprise a polymer which volatilizes at a lower temperature than the polymer of the inner portion, such as core (22). Consequently, by the time the polymer of the inner portion volatilizes, the prior volatilization of the polymer of the outer portion will have created pores for the escape of the gases created by volatization at the core.

Another example embodying the insulation aspect of this invention can be illustrated by composite sheet (30) in Fig. 3 having a layer of conducting ceramic (32) between two layers of insulating ceramic (36). It will be evident to those skilled in the art that the composite sheet can be conveniently produced by first extruding sheets of a composition blended in accordance with this invention to contain a conducting ceramic (or its precursor) and a blend of polymer, plasticizer and insulating ceramic, then layering a sheet with the conducting ceramic (or its precursor) between two sheets with the dielectric ceramic, and feeding the layered composition into a laminator. Alternatively, the composite sheet may be formed by conventional coextrusion where two extruders feed a coextrusion die. In any case, such a composite sheet represents another conveniently produced and shaped composition because it can be fired, with or without prior extraction of the plasticizer, and sintered to form a ceramic sheet having a conducting layer protected by insulating layers. The sheet may be stamped and/or formed during fabrication of products of various shapes prior to sintering. It will be evident that tubes of conducting ceramic can also be provided with both inner and outer layers of insulating ceramic using conventional coextrusion technology.

While the following non-limiting examples 6B and 7B did not employ the co-precipitated ceramic materials described herein, it is believed that such ceramic materials and/or precursors may be used in a manner similar to that of the conducting ceramic or precursors exemplified to produce superconducting products.

## EXAMPLE 6B

The two compositions as used in Example 5B were separately pressed into sheets about 1 mm thick and a sheet of the composition containing the superconductor precursor was laminated together with two sheets of the composition containing the insulating ceramic precursor in a press, with the sheet of composition containing the superconductor precursor between the two sheets of composition containing the insulating ceramic precursor. The oil was extracted from the laminate and the laminate was then sintered as in Example 5B to field a ceramic product having a conducting sheet with insulating ceramic coatings on both surfaces.

## EXAMPLE 7B

The composition of Example 5B which contained insulating ceramic precursor was extruded to form a 2.5 mm diameter rod. A sheet of the plastic composition containing superconductor precursor of Example 1 was wrapped around the rod, and a sheet of the composition containing insulating ceramic precursor was wrapped outside of that to provide a cylindrical charge having a total diameter of 9 mm. This charge was then itself extruded through the tubing die of Example 4B to form approximately 3 mm diameter tubing which, under microscopic examination of sections, proved to have continuous insulating ceramic (a cordierite precursor) composition both inside and outside, separated by the superconductor precursor composition in an about 0.1 mm thick layer continuous through the length of the tube. Due to the die construction, however, the tube of composition containing the superconductor precursor was circumferentially interrupted along the length of the composite tube. The oil was extracted from the composite tube and the hardened tube was heated and sintered to yield a ceramic product of conductor materials in substantially tubular form with continuous insulation inside and outside. It will be evident to those skilled in the art that products without the above-described circumferential interruptions can be readily produced with conventional coextrusion apparatus.

It is noted that coextrusion is not the only means of producing composite materials which can be processed to form integral products having a first portion which exhibits reduced electrical resistivity and a second portion which is an insulator. For example, compositions blended in accordance with this invention can also be heat sealed or bonded to compositions comprising a polymer, a plasticizer, and a ceramic dielectric. Bonding of the two compositions may be conveniently effected by contacting the surfaces to be bonded with a fluid heating medium at a temperature and for a time effective for heat softening those surfaces, and bringing together the surfaces to be bonded and permitting the adjoining surfaces to bond or fuse together. The heating medium may typically be at a temperature of from about 180 °C to about 1200 °C, preferably at least when polyolefins are used for the polymeric components of the compositions, from about 500 °C to about 1000 °C. The time of contact with the heating medium is such as to permit surface bonding without destroying the dimensional stability of the structure, as may occur if each entire composition is heated above its melting point. In general, the time of contact with the heating medium may be from about 0.05 to about 5 seconds. The heating medium may be, for example, air or other gaseous media such as gaseous products of combustion of natural gas, etc. Satisfactory bonding of compositions using polyolefins as their polymeric components may be effected, for example, using a gaseous heating medium at a temperature of about 1000 °C with a heating media contact time of about 0.2 to 2 seconds. Typically, the corresponding bonding surface temperatures are approximately 180 °C to 260 °C, eg. about 200 °C.

Of course, coextrusion and heat sealing or bonding may both be used during production of products in accordance with this invention. For example, a composite bar such as that illustrated in Fig. 2 could be coextruded as described above and coiled. The adjacent windings of the coil could then be heat sealed prior to firing and sintering such that the product which results after sintering is a cohesive and thus a relatively strong tube of coiled ceramic conductor with the windings electrically insulated from one another.

It will be evident that products containing multiple alternating layers of conducting and insulating ceramic can be produced simply by coextruding multiple layers or by heat sealing or bonding compositions having fewer layers.

Another group of products includes those such as the insulated hollow tubes which can be illustrated by (40) in Fig. 4 which are both insulated and contain channels that provide conductivity for circulating fluid coolants. Thus, when conducting elements of the product such as the superconducting tubular core (42) exhibit the desired reduced electrical resistance only when maintained at low temperatures, but nevertheless require insulation, it is advantageous to provide both a ceramic insulator for heat and electricity such as the dielectric annular jacket (46), and channels such as channel (44) through which coolant can be circulated.

A composite tube such as that illustrated in Fig. 4 can be conveniently produced by blending a polymer, plasticizer, and ceramic material in accordance with this invention and extruding it through a conventional extruder fitted with an appropriate tube die. Another composite comprising a polymer, plasticizer, and another, dielectric ceramic may be similarly blended and extruded through a conventional extruder fitted with a tube die sized such that the tube with the conducting ceramic (or precursor) can be fitted within its channel. After the tube with conducting ceramic is fitted within the tube with the insulating ceramic, the composite can then be fed into a ram extruder and re-extruded as a tube composite. Alternatively, a tube of a composition blended in accordance with this invention, as illustrated for example

by Fig. 1, could be heat sealed or bonded to a jacket comprising a polymer, a plasticizer, and a ceramic dielectric. For routine production, dies allowing conventional coextrusion of one or more tubes with conducting ceramic (or precursors) inside of a jacket with dielectric ceramic can also be fabricated. In any case, such a composite tube represents a conveniently produced and shaped composition because it can be fired, with or without prior extraction of plasticizer, and sintered to form a ceramic tube having a conducting layer which can be directly cooled and an insulating jacket.

In some applications of superconductors it has become desirable to provide a layer of conductive metal in contact with the ceramic of reduced electrical resistivity, especially superconductive ceramics. Without confining our invention to a particular theory of operation, it is believed that a layer of conductive metal may retain the integrity of an electrical circuit should the performance of the ceramic conductor be momentarily upset. Generally, the metal cladding will provide additional strength, and in particular toughness, to superconducting ceramics.

It has now been found that composite products such as those illustrated in Figures 2, 3, and 4 can be produced in accordance with this invention, with at least one layer being conductive metal. For example, a silver clad bar of superconducting material which can be illustrated by (20) of Fig. 2, wherein a silver cladding (26) surrounds the conducting ceramic (22). It will be evident that multiple cores may be embedded in the same silver cladding. It will also be evident that rods or tubes containing more than two layers of compositions can be produced using conventional technology. For example, a silver clad superconducting ceramic can itself be provided with a jacket of ceramic insulator.

Although silver is a preferred conductive metal, other conductive metals, such as gold, which are capable of retaining their conductivity without volatilizing upon cofiring in an oxygen-containing atmosphere with the ceramic components, are also considered suitable for use in this invention.

A metal-clad bar such as that illustrated in Fig. 2 can be conveniently produced by blending a polymer, plasticizer, and ceramic material in accordance with this invention and extruding it through a conventional extruder fitted with an appropriate rod die. A second composition comprising a polymer, plasticizer, and particles of the conductive metal, such as silver, may be similarly blended and extruded through a tube die sized such that after extrusion the rod with the conducting ceramic (or precursor) can be inserted within the channel of the tube with conductive metal. This composite can be fed into a ram extruder and re-extruded as a bar composite with the two portions firmly bonded together. Alternatively, one or more rods of ceramic with reduced electrical conductivity (or its precursors) can be coextruded by conventional means in the presence of additional feed consisting of the second composition with conductive metal. In any case, such a composite bar represents a conveniently produced and shaped composition because it can be shaped and fired, with or without prior extraction of the plasticizer(s), and sintered to form a ceramic bar having a conducting core and a cladding of conductive metal integral with the core. For example, one particular application might be to coil the composite bar in its plastic form such that the product which results after firing and sintering (i.e. a ceramic conductor with cladding) is an open coil suitable for electromagnetic applications. It will be evident that an additional layer of ceramic insulation can be provided by coextrusion with an additional layer containing dielectric ceramic as described above.

This group of products produced in accordance with this invention will become further apparent from the following non-limiting example.

## EXAMPLE 5A

A superconducting powder of the general type used in Example 2A and containing yttrium, barium, and copper in an atomic ratio of 1:2:3 was mixed with polyethylene (in particular, GUR 412, available from American Hoechst and having a molecular weight believed to be about 2,000,000) and mineral oil (in particular, Sunthene 255, available from Sun Chemical). The mixture was compounded twice using a roller-head mixer (Haake Rheocord) set at 150° C and 50 rpm. The resulting composition was about 82.3 weight percent powder, about 2.9 weight percent polyethylene, and about 14.8 weight percent oil. A portion of this composition was shaped by extrusion at about 150° C, using a small ram extruder, into rods of about one-sixteenth inch diameter. Separately, silver particles were mixed and compounded with GUR 412 and Sunthene 255 to provide a second composition having about 82.3 weight percent silver, about 2.9 weight percent polyethylene and about 14.8 weight percent oil. The composition containing silver was extruded at about 150° C using the small ram extruder into a tube having an outer diameter of about one-quarter inch. After the tube was cooled, four of the rods containing the superconducting powder were inserted side-by-side into a length of the tube. The filled tube was charged into the ram extruder, reheated to about 150° C,

and re-extruded to form a rod of about one-eighth inch diameter. The rod had a core of composition containing the superconducting powder which was integral with a surrounding composition containing silver. The oil was then extracted from the composite rod by immersion in hexane and the resultant composite rod was dried by evaporation at room temperature. The rod was then gradually heated to 700 °C over two hours, fired for five hours at 700 °C, and heated to about 940 °C (i.e. below the melting point of silver) over one hour such that the polymer and remaining plasticizer were volatalized before the sintering temperature for the ceramic was reached. The rod was then respectively fired for ten hours at 940 °C, cooled to 650 °C over three hours, cooled to 450 °C over six hours, and then allowed to cool to room temperature. These heating, firing, and cooling procedures were accomplished in an atmosphere of oxygen. The silver clad ceramic rod which resulted, when cooled in liquid nitrogen above a permanent magnet, showed levitation. Moreover, the rod was also conductive at room temperature, presumably due to the silver cladding.

Another example embodying the metal-cladding aspect of this invention can be illustrated by the composite sheet (30) in Fig. 3 having a layer of conducting ceramic (32) between two layers of conductive metal (36). It will be evident to those skilled in the art that the composite sheet can be conveniently produced by first extruding sheets of a composition blended in accordance with this invention to contain a conducting ceramic (or its precursor) and a blend of polymer, plasticizer and conductive metal, then layering a sheet with the conducting ceramic (or its precursor) between two sheets with the conductive metal, and feeding the layered composition into a laminator. Alternatively, the composite sheet may be formed by conventional coextrusion where two extruders feed a coextrusion die. In any case, such a composite sheet represents another conveniently produced and shaped composition because it can be fired, with or without prior extraction of the plasticizer, and sintered to form a ceramic sheet having a conducting ceramic layer protected between conductive metal layers. The sheet may be stamped and/or formed during fabrication of products of various shapes prior to sintering. It will be evident that tubes of conducting ceramic can also be provided with both inner and outer layers of metal cladding using conventional coextrusion technology. Moreover, both insulating layers and metal cladding layers can be combined with layers of conductive ceramics as desired, thereby increasing the utility of the conducting ceramics.

It is noted that coextrusion is not the only means of producing composite materials which can be processed to form integral products having a first ceramic portion which exhibits reduced electrical resistivity and additional portions which may each be either insulators or conductive metals. For example, heat sealing or bonding as generally described above may be employed. It will be evident that products containing multiple alternating layers can be produced simply by coextruding multiple layers or by heat sealing or bonding compositions having fewer layers.

Another group of products includes those such as insulated hollow tubes which can be illustrated by (40) in Fig. 4 which are both metal-clad and contain channels that provide conductivity for circulating fluid coolants. Thus, when conducting elements of the product such as the superconducting tubular core (42) exhibit the desired reduced electrical resistance only when maintained at low temperatures, but nevertheless require conductivity at room temperature, it is advantageous to provide both a conductive metal for electricity such as the metal cladding (46), and channels such as channel (44) through which coolant can be circulated. It will be evident that a jacket of ceramic insulator could also be provided.

The examples describe various embodiments of the invention. Other embodiments will be apparent to those skilled in the art from a consideration of the specification or practice of the invention disclosed herein. It is understood that modifications and variations may be practiced without departing from the spirit and scope of the novel concepts of this invention. It is further understood that the invention is not confined to the particular formulations and examples herein illustrated, but it embraces such modified forms thereof as come within the scope of the following claims.

## Claims

1. A composition for forming superconducting ceramics comprising a substantially uniform plastic blend of:

(a) at least about 60 weight percent total of particles of superconductive ceramic materials having the formula $(L_wM_x)_vA_yD_z$ where L, M, and A are metallic components of the ceramic and D is oxygen, and w, x, v, y, and z define the relative proportions of the components or particles of precursors of ceramic material having said formula, or both particles of said ceramic materials and particles of precursors of said ceramic material, said ceramic materials being produced by the steps of:

(i) preparing a solution of soluble salts of L, M, and A with the components L, M, and A in the

predetermined atomic ratio of said formula;
(ii) preparing a solution of quaternary ammonium carbonate;
(iii) mixing said L.M.A. and quaternary ammonium carbonate solutions by simultaneously stirring them into a pool of water to fcrm a stoichiometric co-precipitate;
(iv) recovering said co-precipitate; and
(v) calcining the coprecipitate; and said precursors being produced by said steps (i) through (iv) without total calcination;

(b) from about 2 to about 10 weight percent total of at least one polymer which has a volatilization temperature below the sintering temperature of said particles, and which has a molecular weight of at least about 100,000; and

(c) about 30 weight percent or less of a plasticizer for said polymer which can be removed either by extraction or by volatilization at a temperature below the volatilization temperature of the polymer; wherein the polymer and the plasticizer are unreactive with the particles of component (a) such that the particles remain substantially unchanged during blending; and wherein the polymer, at least in the presence of the plasticizer, is one that can be made fluid during processing such that it can be blended with the ceramic and plasticizer components and is one that can be solidified after blending.

2. The composition of Claim 1 wherein the particles of component (a) are particles of ceramic material.

3. The composition of Claim 1 wherein L is at least one trivalent metal, M is at least one bivalent metal, and A is at least one metal of multiple valency.

4. The composition of Claim 1 wherein L is selected from the group consisting of Y, La, Nd, Sm, Eu, Gd, Dy, Ho, Yb, Lu, and Sc; wherein M is selected from the group consisting of Sr, Ca, and Ba; wherein A is Cu, and D is O.

5. The composition of Claim 4 wherein component (a) is particles of a ceramic material having a formula represented by $Y\ Ba_{1.67x}\ Cu_{0.83y}\ O_{0.83z}$.

6. The composition of Claim 5 wherein x, y, and z are respectively about 1.2, 3.6, and 8.4.

7. The composition of Claim 4 wherein w, x, v, y, and z are respectively about 0.6, 1.2, 2.0, 3.6, and 8.4.

8. The composition of Claim 1 wherein the particles of component (a) are particles of precursor produced by heating the dried co-precipitate of step (iv) to a temperature sufficient to decompose or otherwise volatilize any remaining quaternary ammonium and nitrate material and to achieve partial conversion of carbonates in the precipitate to oxides.

9. The composition of Claim 8 wherein component (a) is particles of $Y_2O_3$, $BaCO_3$, and CuO in a mole ratio of about 1:4:6, respectively.

10. The composition of Claim 1 wherein the composition is shaped as a rod.

11. The composition of Claim 1 wherein the composition is shaped as a tube.

12. The composition of Claim 1 wherein the composition is shaped as a sheet.

13. The composition of Claim 1 wherein the non-ceramic components volatilize without producing significant amounts of carbonaceous residue that upon sintering of the particles prevents the development of reduced electrical resistivity.

14. The composition of Claim 1 wherein the polymer is selected from the group consisting of polyethylene, polypropylene, and polystyrene; and wherein the plasticizer is selected from the group consisting of mineral oil, diethylene glycol, propylene glycol, dipropylene glycol, glycerin, glycerol monoacetate, trimethylene glycol, tetramethylene glycol, 2,3-butylene glycol, triethyl phosphate, polyvinyl alcohol, and polyvinyl pyrrolidone.

15. A method for forming shaped superconducting solid products having superconductor with the formula $(L_wM_x)_vA_yD_z$, comprising the steps of:

(a) providing a superconducting ceramic produced by the steps of:
(i) preparing a solution of soluble salts of L, M, and A with the components L, M, and A in the predetermined atomic ratio of said formula;
(ii) preparing a solution of quaternary ammonium carbonate;
(iii) mixing said L.M.A. and quaternary ammonium carbonate solutions by simultaneously stirring them into a pool of water to form a stoichiometric co-precipitate;
(iv) recovering said co-precipitate; and
(v) calcining the coprecipitate; and said precursors being produced by said steps (i) through (iv) without total calcination;

(b) compounding said ceramic with at least one polymer which has a molecular weight of at least about 100,000, and a plasticizer for said polymer to produce a substantially uniform plastic blend comprising at least about 60 weight percent of particles of ceramic materials which exhibit superconductivity; from about 2 to about 10 weight percent total of said polymer; and about 30 weight percent or less of

said plasticizer; wherein the polymer component and the plasticizer component are unreactive with the particles of the ceramic component such that the particles remain substantially unchanged during blending; and wherein the polymer, at least in the presence of the plasticizer, is one that can be made fluid during processing such that it can be blended with the ceramic and plasticizer components, and is one that can be solidified after blending;

(c) shaping the composition into the shape desired for the shaped solid products;

(d) removing the plasticizer by extraction or volatilization;

(e) heating the blend to volatilize the polymer; and

(f) firing the composition to at least about 900 °C to sinter the ceramic components.

16. The method of Claim 15 wherein the plasticizer is at least partially extracted with a solvent after shaping and prior to firing.

17. The method of Claim 15 wherein the polymer is thermoplastic such that it can be made fluid and solidified by respectively raising and lowering the temperature of the polymer.

18. The method of Claim 15 wherein the polymer is a polyolefin.

19. An integral ceramic solid comprising a first portion which has superconductivity and a second portion which is a dielectric insulator formed by:

(a) providing a first composition which is a substantially uniform blend comprising at least about 60 weight percent of superconducting ceramic materials having the formula $(L_wM_x)_vA_yD_z$ where L, M, and A are metallic components and D is oxygen, and w, x, v, y, and z define the relative proportions of the components, particles of precursors of said ceramic material, of both; from about 2 to about 10 weight percent total of at least one polymer which has a molecular weight of at least about 100,000; and from about 2 to about 30 weight percent of a plasticizer for said polymer; wherein the polymer component and the plasticizer component are unreactive with the particles of the ceramic component such that the particles remain substantially unchanged during blending; wherein the polymer, at least in the presence of the plasticizer is one that can be made fluid for blending and is one that can be solidified after blending; and wherein said superconducting ceramic material is produced by the steps of:

(i) preparing a solution of soluble salts of L, M, and A with the components L, M, and A in the predetermined atomic ratio of said formula;

(ii) preparing a solution of quaternary ammonium carbonate;

(iii) mixing said L.M.A. and quaternary ammonium carbonate solutions by simultaneously stirring them into a pool of water to form a stoichiometric co-precipitate;

(iv) recovering said co-precipitate; and

(v) calcining the coprecipitate; and said precursors are produced by said steps (i) through (iv) without total calcination;

(b) providing a second composition which is a blend comprising a polymer, a plasticizer, and particles of a dielectric ceramic or its precursors;

(c) firmly bonding said first composition to said second composition; and

(d) firing the bonded blends such that the temperature first attains a range to volatilize the non-ceramic components and then is raised to a temperature of at least about 900 °C, said temperature being sufficient to sinter the ceramic particles or their precursors without volatilizing them.

20. The integral ceramic solid of Claim 19 wherein, during its formation, the blend is bonded to the second compositon by coextrusion.

21. The integral ceramic solid of Claim 19 wherein, during its formation, the blend is bonded to the second compositon by heat sealing.

22. The integral ceramic solid of Claim 19 comprising a composite bar having a first portion which is a cylindrical core of superconducting material and a second portion which is an annular jacket that provides electrical insulation.

23. The integral ceramic solid of Claim 22 wherein, during formation, the composite bar is coiled and its adjacent windings are bonded prior to firing and sintering such that the integral solid is a cohesive tube of coiled ceramic superconductor with the windings electrically insulated from one another.

24. The integral ceramic solid of Claim 19 comprising a sheet of superconducting ceramic layered between two sheets of insulating ceramic.

25. An integral solid comprising a metal-clad superconductive ceramic formed by:

(a) providing a first composition which is a substantially uniform blend comprising at least about 60 weight percent of superconducting ceramic materials having the formula $(L_wM_x)_vA_yD_z$ where L, M, and A are metallic components and D is oxygen, and w, x, v, y, and z define the relative proportions of the components, particles of precursors of said ceramic material, or both; from about 2 to about 10 weight percent total of at least one polymer which has a molecular weight of at least about 100,000; and from

about 2 to about 30 weight percent of a plasticizer for said polymer; wherein the polymer component and the plasticizer component are unreactive with the particles of the ceramic component such that the particles remain substantially unchanged during blending; wherein the polymer, at least in the presence of the plasticizer is one that can be made fluid for blending and is one that can be solidified after blending; and wherein said superconducting ceramic material is produced by the steps of:
(i) preparing a solution of soluble salts of L, M, and A with the components L, M, and A in the predetermined atomic ratio of said formula;
(ii) preparing a solution of quaternary ammonium carbonate;
(iii) mixing said L.M.A. and quaternary ammonium carbonate solutions by simultaneously stirring them into a pool of water to form a stoichiometric co-precipitate;
(iv) recovering said co-precipitate: and
(v) calcining the coprecipitate; and said precursors are produced by said steps (i) through (iv) without total calcination;

(b) providing a second composition which is a blend comprising a polymer, a plasticizer, a d particles of a conductive metal;

(c) firmly bonding said first composition to said second composition; and

(d) firing the bonded blends such that the temperature first attains a range to volatilize the non-ceramic components and then is raised to a temperature of at least about 900° C, said temperature being sufficient to sinter the ceramic particles or their precursors without volatilizing them.

26. The integral solid of Claim 25 wherein, during its formation, the blend is bonded to the second compositon by coextrusion.

27. The integral solid of Claim 25 wherein, during its formation, the blend is bonded to the second compositon by heat sealing.

28. The integral solid of Claim 25 comprising a metal-clad bar of superconducting ceramic material.

29. The integral solid of Claim 28 wherein the conductive metal is silver.

30. The integral solid of Claim 25 comprising a sheet of superconducting ceramic layered between two sheets of conductive metal.

Claims for the following Contracting State: ES

1. A method for forming shaped superconducting solid products having superconductor with the formula $(L_wM_x)_vA_yD_z$, comprising the steps of:

(a) providing a superconducting ceramic produced by the steps of:
(i) preparing a solution of soluble salts of L, M, and A with the components L, M, and A in the predetermined atomic ratio of said formula;
(ii) preparing a solution of quaternary ammonium carbonate;
(iii) mixing said L.M.A. and quaternary ammonium carbonate solutions by simultaneously stirring them into a pool of water to form a stoichiometric co-precipitate;
(iv) recovering said co-precipitate; and
(v) calcining the coprecipitate; and said precursors being produced by said steps (i) through (iv) without total calcination;

(b) compounding said ceramic with at least one polymer which has a molecular weight of at least about 100,000, and a plasticizer for said polymer to produce a substantially uniform plastic blend comprising at least about 60 weight percent of particles of ceramic materials which exhibit superconductivity; from about 2 to about 10 weight percent total of said polymer; and about 30 weight percent or less of said plasticizer; wherein the polymer component and the plasticizer component are unreactive with the particles of the ceramic component such that the particles remain substantially unchanged during blending; and wherein the polymer, at least in the presence of the plasticizer, is one that can be made fluid during processing such that it can be blended with the ceramic and plasticizer components, and is one that can be solidified after blending;

(c) shaping the composition into the shape desired for the shaped solid products;

(d) removing the plasticizer by extraction or volatilization;

(e) heating the blend to volatilize the polymer; and

(f) firing the composition to at least about 900° C to sinter the ceramic components.

2. The method of Claim 1 wherein the plasticizer is at least partially extracted with a solvent after shaping and prior to firing.

3. The method of Claim 1 wherein the polymer is thermoplastic such that it can be made fluid and solidified by respectively raising and lowering the temperature of the polymer.

4. The method of Claim 1 wherein the polymer is a polyolefin.

5. A composition for forming superconducting ceramics comprising a substantially uniform plastic blend of:

(a) at least about 60 weight percent total of particles of superconductive ceramic materials having the formula $(L_wM_x)_vA_yD_z$ where L, M, and A are metallic components of the ceramic and D is oxygen, and w, x, v, y, and z define the relative proportions of the components or particles of precursors of ceramic material having said formula, or both particles of said ceramic materials and particles of precursors of said ceramic material, said ceramic materials being produced by the steps of:

(i) preparing a solution of soluble salts of L, M, and A with the components L, M, and A in the predetermined atomic ratio of said formula;

(ii) preparing a solution of quaternary ammonium carbonate;

(iii) mixing said L.M.A. and quaternary ammonium carbonate solutions by simultaneously stirring them into a pool of water to form a stoichiometric co-precipitate;

(iv) recovering said co-precipitate, and

(v) calcining the coprecipitate; and said precursors being produced by said steps (i) through (iv) without total calcination;

(b) from about 2 to about 10 weight percent total of at least one polymer which has a volatilization temperature below the sintering temperature of said particles, and which has a molecular weight of at least about 100,000; and

(c) about 30 weight percent or less of a plasticizer for said polymer which can be removed either by extraction or by volatilization at a temperature below the volatilization temperature of the polymer; wherein the polymer and the plasticizer are unreactive with the particles of component (a) such that the particles remain substantially unchanged during blending; and wherein the polymer, at least in the presence of the plasticizer, is one that can be made fluid during processing such that it can be blended with the ceramic and plasticizer components and is one that can be solidified after blending.

6. The composition of Claim 5 wherein the particles of component (a) are particles of ceramic material.

7. The composition of Claim 5 wherein L is at least one trivalent metal, M is at least one bivalent metal, and A is at least one metal of multiple valency.

8. The composition of Claim 5 wherein L is selected from the group consisting of Y, La, Nd, Sm, Eu, Gd, Dy, Ho, Yb, Lu, and Sc; wherein M is selected from the group consisting of Sr, Ca, and Ba; wherein A is Cu, and D is O.

9. The composition of Claim 8 wherein component (a) is particles of a ceramic material having a formula represented by $Y\ Ba_{1.67x}\ Cu_{0.83y}\ O_{0.83z}$.

10. The composition of Claim 9 wherein x, y, and z are respectively about 1.2, 3.6, and 8.4.

11. The composition of Claim 8 wherein w, x, v, y, and z are respectively about 0.6, 1.2, 2.0, 3.6, and 8.4.

12. The composition of Claim 5 wherein the particles of component (a) are particles of precursor produced by heating the dried co-precipitate of step (iv) to a temperature sufficient to decompose or otherwise volatilize any remaining quaternary ammonium and nitrate material and to achieve partial conversion of carbonates in the precipitate to oxides.

13. The composition of Claim 12 wherein component (a) is particles of $Y_2O_3$, $BaCO_3$, and CuO in a mole ratio of about 1:4:6, respectively.

14. The composition of Claim 5 wherein the composition is shaped as a rod.

15. The composition of Claim 5 wherein the composition is shaped as a tube.

16. The composition of Claim 5 wherein the composition is shaped as a sheet.

17. The composition of Claim 5 wherein the non-ceramic components volatilize without producing significant amounts of carbonaceous residue that upon sintering of the particles prevents the development of reduced electrical resistivity.

18. The composition of Claim 5 wherein the polymer is selected from the group consisting of polyethylene, polypropylene, and polystyrene; and wherein the plasticizer is selected from the group consisting of mineral oil, diethylene glycol, propylene glycol, dipropylene glycol, glycerin, glycerol monoacetate, trimethylene glycol, tetramethylene glycol, 2,3-butylene glycol, triethyl phosphate, polyvinyl alcohol polyvinyl pyrrolidone.

19. An integral ceramic solid comprising a first portion which has superconductivity and a second portion which is a dielectric insulator formed by:

(a) providing a first composition which is a substantially uniform blend comprising at least about 60 weight percent of superconducting ceramic materials having the formula $(L_wM_x)_vA_yD_z$ where L, M, and A are metallic components and D is oxygen, and w, x, v, y, and z define the relative proportions of the

components, particles of precursors of said ceramic material, or both; from about 2 to about 10 weight percent total of at least one polymer which has a molecular weight of at least about 100,000; and from about 2 to about 30 weight percent of a plasticizer for said polymer; wherein the polymer component and the plasticizer component are unreactive with the particles of the ceramic component such that the particles remain substantially unchanged during blending; wherein the polymer, at least in the presence of the plasticizer is one that can be made fluid for blending and is one that can be solidified after blending; and wherein said superconducting ceramic material is produced by the steps of:
(i) preparing a solution of soluble salts of L, M, and A with the components L, M, and A in the predetermined atomic ratio of said formula;
(ii) preparing a solution of quaternary ammonium carbonate;
(iii) mixing said L.M.A. and quaternary ammonium carbonate solutions by simultaneously stirring them into a pool of water to form a stoichiometric co-precipitate;
(iv) recovering said co-precipitate: and
(v) calcining the coprecipitate; and said precursors are produced by said steps (i) through (iv) without total calcination;

(b) providing a second composition which is a blend comprising a polymer, a plasticizer, and particles of a dielectric ceramic or its precursors;

(c) firmly bonding said first composition to said second composition; and

(d) firing the bonded blends such that the temperature first attains a range to volatilize the non-ceramic components and then is raised to a temperature of at least about 900° C, said temperature being sufficient to sinter the ceramic particles or their precursors without volatilizing them.

20. The integral ceramic solid of claim 19 wherein, during its formation, the blend is bonded to the second compositon by coextrusion.

21. The integral ceramic solid of claim 19 wherein, during its formation, the blend is bonded to the second compositon by heat sealing.

22. The integral ceramic solid of Claim 19 comprising a composite bar having a first portion which is a cylindrical core of superconducting material and a second portion which is an annular jacket that provides electrical insulation.

23. The integral ceramic solid of Claim 22 wherein, during formation, the composite bar is coiled and its adjacent windings are bonded prior to firing and sintering such that the integral solid is a cohesive tube of coiled ceramic superconductor with the windings electrically insulated from one another.

24. The integral ceramic solid of Claim 19 comprising a sheet of superconducting ceramic layered between two sheets of insulating ceramic.

25. An integral solid comprising a metal-clad superconductive ceramic formed by:

(a) providing a first composition which is a substantially uniform blend comprising at least about 60 weight percent of superconducting ceramic materials having the formula $(L_wM_x)_vA_yD_z$ where L, M, and A are metallic components and D is oxygen, and w, x, v, y, and z define the relative proportions of the components, particles of precursors of said ceramic material, or both; from about 2 to about 10 weight percent total of at least one polymer which has a molecular weight of at least about 100,000; and from about 2 to about 30 weight percent of a plasticizer for said polymer; wherein the polymer component and the plasticizer component are unreactive with the particles of the ceramic component such that the particles remain substantially unchanged during blending; wherein the polymer, at least in the presence of the plasticizer is one that can be made fluid for blending and is one that can be solidified after blending; and wherein said superconducting ceramic material is produced by the steps of:
(i) preparing a solution of soluble salts of L, M, and A with the components L, M, and A in the predetermined atomic ratio of said formula;
(ii) preparing a solution of quaternary ammonium carbonate;
(iii) mixing said L.M.A. and quaternary ammonium carbonate solutions by simultaneously stirring them into a pool of water to form a stoichiometric co-precipitate;
(iv) recovering said co-precipitate and
(v) calcining the coprecipitate; and said precursors are produced by said steps (i) through (iv) without total calcination;

(b) providing a second composition which is a blend comprising a polymer, a plasticizer, and particles of a conductive metal;

(c) firmly bonding said first composition to said second composition; and

(d) firing the bonded blends such that the temperature first attains a range to volatilize the non-ceramic components and then is raised to a temperature of at least about 900° C, said temperature being sufficient to sinter the ceramic particles or their precursors without volatilizing them.

26. The integral solid of Claim 25 wherein, during its formation, the blend is bonded to the second compositon by coextrusion.

27. The integral solid of Claim 25 wherein, during its formation, the blend is bonded to the second compositon by heat sealing.

28. The integral solid of Claim 25 comprising a metal-clad bar of superconducting ceramic material.

29. The integral solid of Claim 28 wherein the conductive metal is silver.

30. The integral solid of Claim 25 comprising a sheet of superconducting ceramic layered between two sheets of conductive metal.

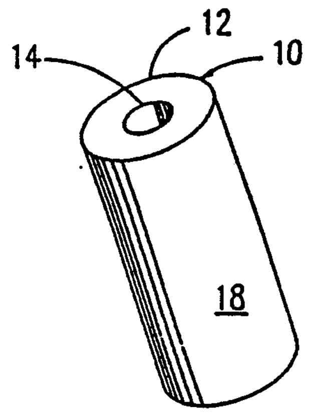


FIG. 1

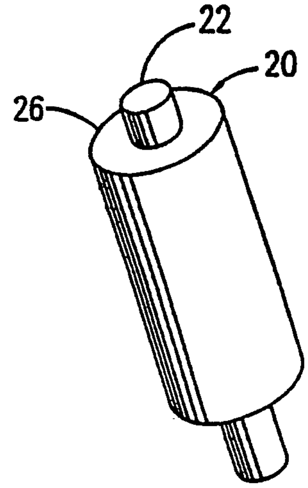


FIG. 2

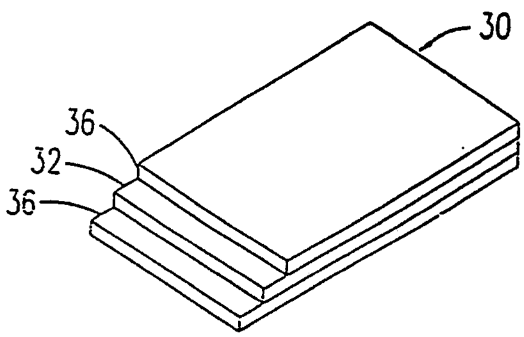


FIG. 3

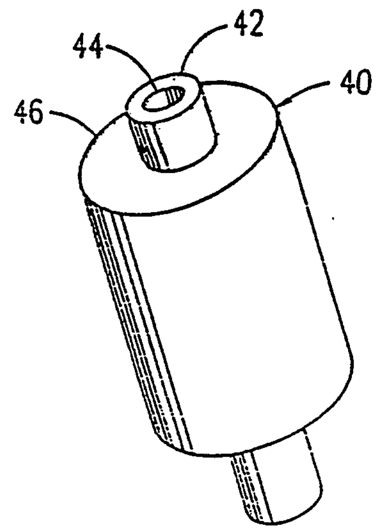


FIG. 4